# FASCICULE DE BREVET EUROPEEN

(11) **EP 2 065 906 B1**
(45) Date de publication et mention de la délivrance du brevet: **15.07.2015**
(21) Numéro de dépôt: 08169819.3
(22) Date de dépôt: 24.11.2008
(51) Int. Cl.: H01F 10/24, H01L 21/762, C30B 33/06, H01F 41/34

(54) **Procédé de modération de déformation**
Verfahren zur Schwächung der Verformung
Process for moderating deformation

(30) Priorité: 28.11.2007 FR 0759392
(43) Date de publication de la demande: 03.06.2009
(73) Titulaire: Commissariat à l'Énergie Atomique et aux Énergies Alternatives, 75015 Paris (FR)
(72) Inventeur: Moriceau, Hubert, 38120 SAINT EGREVE (FR); Roussin, Jean-Claude, 38600 FONTAINE (FR)
(74) Mandataire: Ilgart, Jean-Christophe

(56) Documents cités:
- FR-A- 2 789 518
- US-A1- 2004 067 622
- US-A1- 2005 153 524
- IZUHARA T ET AL: "Direct wafer bonding and transfer of 10-[mu]m-thick magnetic garnet films onto semiconductor surfaces" APPLIED PHYSICS LETTERS, AIP, AMERICAN INSTITUTE OF PHYSICS, MELVILLE, NY, vol. 76, no. 10, 6 mars 2000 (2000-03-06), pages 1261-1263, XP012024771 ISSN: 0003-6951
- MANTL S ET AL: "Strain relaxation of epitaxial SiGe layers on Si(100) improved by hydrogen implantation" NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, vol. 147, no. 1-4, 1 janvier 1999 (1999-01-01), pages 29-34, XP004196272 ISSN: 0168-583X

## Description

### DOMAINE TECHNIQUE ET ART ANTERIEUR

L'invention concerne un procédé perfectionné d'assemblage de couches sur un substrat.

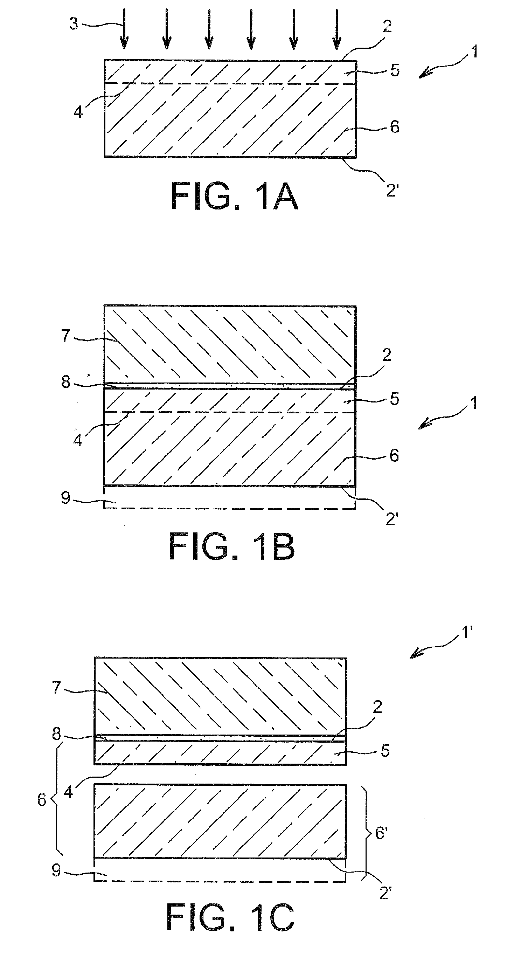

Les figures 1A à 1C illustrent un exemple de mise en oeuvre d'un procédé de transfert de couche de type connu. Ces figures sont des vues en coupe transversale.

La figure 1A montre un substrat en silicium 1 au cours de l'étape d'implantation d'une espèce gazeuse. Pour cela, la face 2 de ce substrat est soumise à une implantation ionique symbolisée par les flèches 3. Pour un substrat en silicium, on peut par exemple implanter de l'hydrogène pour une énergie de 200 keV et pour une dose de l'ordre de 6.10¹⁶ H⁺/cm². Il se forme alors une couche 4 constituant une zone fragilisée, qui sépare le substrat 1 en deux parties : une couche mince 5, située entre la face implantée 2 et la zone fragilisée 4, et la partie restante 6 du substrat située sous la zone fragilisée 4.

La figure 1B illustre une étape de solidarisation de la face 2 du substrat 1 sur un substrat support 7 ou raidisseur. La solidarisation peut être obtenue par différents moyens : par une substance adhésive ou par collage direct par adhésion moléculaire par exemple. Une couche de collage 8 peut aussi être utilisée. Par exemple, lorsque le substrat 1 est en silicium, une couche d'oxyde peut être formée sur sa face 2. Si le raidisseur 7 possède lui aussi une couche d'oxyde de silicium, la mise en contact des deux couches d'oxyde constitue alors la couche de collage.

La figure 1C illustre une étape de séparation, induite par effet thermique, de la couche mince 5 et d'une partie restante 6' du substrat 6, le long de la zone fragilisée 4. On peut ainsi obtenir une structure 1' du type silicium sur isolant (structure SOI).

Mais, dans un tel procédé de transfert de film, basé sur l'implantation ionique, puis le collage, de mauvais résultats sont obtenus lorsque la plaque implantée 6 présente une courbure trop importante.

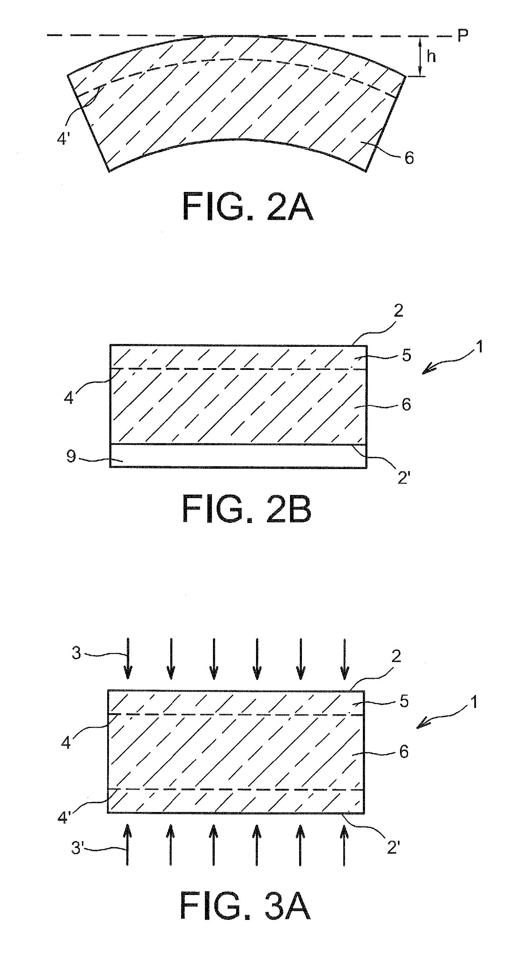

La courbure de la plaque 6, non visible sur les figures 1A - 1C, correspond à une concavité ou à une convexité. Un exemple en est représenté, de manière exagérée, sur la figure 2A.

On caractérise cette courbure par une mesure de flèche, correspondant à la distance maximum h entre un plan de référence P (ici tangent à une surface de la plaque 6) et la surface 2 de cette même plaque. La courbure peut être sans inflexion (« bow » en terminologie anglaise), ou être plus complexe, avec des inflexions («warp»).

La courbure trop importante peut avoir été formée avant implantation, ou peut avoir été provoquée par l'implantation ionique ou atomique.

On constate aussi que, dans bon nombre de cas, cette déformation rend la préparation de surface (planarisation mécano-chimique,...) et le collage direct impossibles.

Une technique classique de compensation de cette courbure consiste à déposer un film contraint 9 sur la face 2' de la plaque, opposée à la face 2 de collage (figures 1A - 1C). La figure 2B représente la plaque 6 avec sa zone de fragilisation 4 et son film contraint 9.

Le moment, associé à la contrainte du film 9, permet de compenser la courbure de la plaque 6, si le signe et l'intensité de la contrainte ont été judicieusement choisis.

Une telle technique de compensation permet d'obtenir un collage, selon les étapes des figures 1B et 1C, relativement correct à température ambiante, en supposant que la plaque 7 ne présente pas, elle-même, de déformation excessive.

Or, on constate que les transferts réalisés dans ces conditions sont parfois de mauvaise qualité, par exemple si le transfert est obtenu lors d'un traitement thermique.

Ceci peut être dû à des différences entre les coefficients de dilatation thermique du film 9 de compensation de contrainte, de la plaque implantée 6 et de la seconde plaque collée 7. Ce traitement thermique entraîne alors une modification de la courbure de la structure collée.

En outre, lors de l'étape de fracture (décrite ci-dessus en liaison avec la figure 1C), le reste 6' de la plaque initiale et le film de compensation 9 sont brusquement soumis à un changement de courbure, en fait une flexion, imposée par la présence du film de compensation. La conséquence en est un risque important de rupture de la partie restante 6' de la plaque initiale 6.

Le brusque changement de convexité (concavité) peut aussi entraîner un mouvement relatif des deux plaques. Il y a donc, également, un risque important de dégradation de l'état de surface de chacune des deux plaques, lié à une friction indésirable entre les deux plaques.

### EXPOSÉ DE L'INVENTION

Selon l'invention on met en oeuvre deux zones de fragilisation, l'une au voisinage de la face de collage et l'autre au voisinage de la face opposée à la face de collage. On induit ainsi un effet de modération ou de compensation de déformation.

L'invention concerne en particulier un procédé de transfert d'une couche en un premier matériau sur un deuxième substrat en un deuxième matériau, comportant :
a) une étape de formation d'un premier plan de fragilisation dans un premier substrat en premier matériau,
b) une étape de formation d'un deuxième plan de fragilisation dans ledit premier substrat, afin de réduire une courbure du premier substrat,
c) une étape d'assemblage des premier et deuxième substrats, par exemple par collage direct ou adhésion moléculaire, ou de dépôt du deuxième substrat sur le premier substrat,
d) une étape de séparation d'une couche du premier substrat au niveau du premier plan de fragilisation, sans séparation au niveau du deuxième plan de fragilisation.

Les zones de fragilisation peuvent être obtenues par exemple par une première et une deuxième implantations de type ionique et/ou atomique à travers, respectivement, la première face libre du substrat et la deuxième face libre du substrat, opposée à la première.

Le premier substrat peut présenter une courbure initiale, avant même l'étape a). Ou bien, une telle courbure peut être créée ou accentuée par la première implantation ionique et/ou atomique à travers la première face dudit substrat.

Les premières et deuxièmes zones de fragilisation sont formées respectivement au voisinage d'une première et d'une deuxième face du premier substrat, et l'étape d'assemblage a lieu par la première face du premier substrat.

De préférence, le premier substrat a, après étape de formation d'une première et d'une deuxième zone de fragilisation, une flèche inférieure à 10 µm.

Les implantations peuvent être réalisées sensiblement aux mêmes doses et aux mêmes énergies, ou à des doses et/ou des énergies différentes, ce qui peut être particulièrement avantageux dans le cas où le premier matériau et le deuxième matériau ont des coefficients de dilatation thermique différents ou des courbures initiales différentes.

La modération ou la compensation de courbure obtenue par l'invention est totale ou quasi totale ou partielle.

En outre, il y a une forte diminution (ou même la disparition) de la modération, ou de la compensation, de déformation lors de l'étape d), donc en même temps que la séparation de la couche du premier substrat.

L'effet de la deuxième implantation disparaît en tout ou en partie, au moment de la fracture ou de la séparation au niveau de la première implantation. Le risque de rupture de la partie restante de la plaque initiale, par brusque changement de courbure, est donc très fortement diminué voire éliminé.

Est également fortement diminué voire éliminé tout mouvement relatif des deux substrats, lié aux changements brusques de courbure, et donc tout risque associé de dégradation.

Le procédé selon l'invention garde son efficacité aux diverses températures des traitements thermiques utilisés avant la séparation, à la différence de la technique antérieure à base de couches de compensation, en particulier lorsqu'il y a une différence de coefficient de dilatation thermique entre les différents substrats.

L'invention s'applique notamment au cas d'un substrat simple. Mais, d'une façon générale, on peut appliquer cette technique de modération de déformation à tout type de matériau, qu'il soit unique ou composite.

Le substrat initial peut donc être homogène, ou comporter un ou plusieurs dépôts, sur l'une et/ou l'autre de ses deux faces (face d'assemblage et face opposée à la face d'assemblage).

L'invention s'applique notamment à des substrats assez raides, difficiles à déformer pour les préparer avant collage ou pour le collage. Il s'agit par exemple de substrats en SiC ou en saphir ou en grenat,...etc. Elle s'applique à des substrats semiconducteurs.

### BRÈVE DESCRIPTION DES DESSINS

- Les figures 1A à 1C représentent un procédé de l'art antérieur,
- les figures 2A et 2B représentent respectivement une déformation d'un substrat et un substrat muni d'une couche de renforcement,
- les figures 3A à 3D représentent un mode de réalisation de l'invention,
- la figure 4 représente un substrat mis en oeuvre dans le cadre d'un exemple de l'invention,
- les figures 5A et 5B illustrent un effet de compensation, par un procédé selon l'invention, dans un empilement de substrats.

### EXPOSÉ DÉTAILLÉ DE MODES DE RÉALISATION PARTICULIERS

Un mode de réalisation de l'invention va être décrit en liaison avec les figures 3A - 3C.

Selon l'invention, on implante le premier substrat 6 à travers chacune de ses faces 2, 2'. La face 2 est destinée à être assemblée avec la surface d'un substrat raidisseur 7. En variante, le substrat raidisseur 7 peut être réalisé par dépôt sur la face 2. La face 2' est la face opposée à la face 2.

Dans le cas d'un matériau homogène, et donc identique sur les deux faces, les implantations peuvent être réalisées à la même dose et à la même énergie sur les deux faces. Il y a création de contraintes des deux côtés ou à proximité des deux faces. Les contraintes et leurs évolutions dans le substrat implanté 6 sont, après les deux implantations, quasiment identiques au voisinage de chacune des deux faces 2, 2'

Pour chaque implantation, la profondeur d'implantation Rp est une profondeur moyenne, à partir de la surface du substrat à travers laquelle elle est réalisée. Cette profondeur moyenne est celle à laquelle est localisé le maximum du profil d'implantation et est liée à l'énergie d'implantation.

L'implantation induit une contrainte, essentiellement située autour de ce pic d'implantation. Cette contrainte induite résulte à son tour en un moment de flexion du substrat.

On peut adapter cette contrainte, donc le moment de flexion, et par conséquent la modération de courbure du substrat implanté. Ainsi, on peut modifier la nature des ions implantés de part et d'autre, afin de faire varier la contrainte induite ou d'obtenir une contrainte résultante d'une certaine valeur.

En outre, la technique d'implantation ionique ou atomique, permet d'implanter à une profondeur moyenne constante qui ne dépend que de l'énergie d'implantation et pas de la forme de la surface.

Cette implantation des deux faces pour compenser des déformations permet d'obtenir un premier substrat implanté 6, sans, ou quasiment sans, courbure ajoutée par l'implantation, en vue d'un collage de bonne qualité avec un second substrat 7.

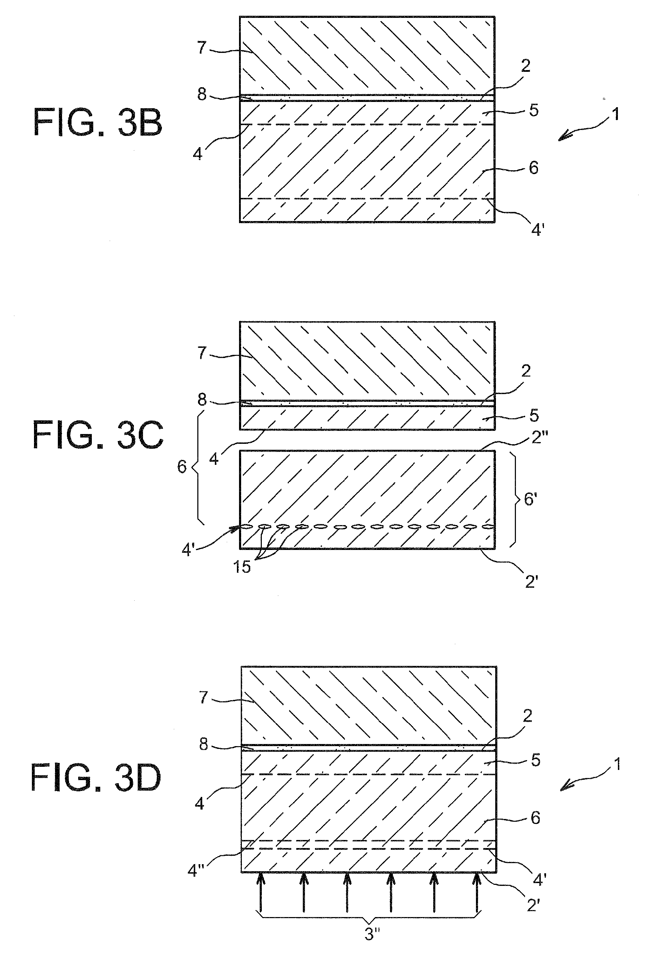

La figure 3B illustre l'étape de solidarisation de la face 2 du substrat 6 sur un substrat support 7 ou raidisseur, solidarisation obtenue par collage direct ou adhésion moléculaire, éventuellement avec une ou plusieurs couches 8 d'aide ou d'assistance au collage direct. Comme déjà indiqué, ce substrat support 7 ou raidisseur peut être obtenu par dépôt d'un film épais sur le substrat 6.

La figure 3C illustre l'étape de séparation, induite par exemple par effet thermique (à température de plusieurs centaines de °C, par exemple comprise entre 150°C et 1200°C, pendant une durée pouvant aller de quelques minutes à plusieurs heures, par exemple comprise entre 4h et 10h).

Là encore, comme sur la figure 1C, la couche mince 5 transférée sur la seconde plaque 7 est prélevée dans la plaque initiale implantée 6. Mais, cette fois, les traitements thermiques lors des étapes des figures 1B et 1C n'engendrent pas de courbure indésirée ou néfaste de la plaque 6 doublement implantée. En effet l'évolution de la contrainte est la même, on quasiment la même, au voisinage de chacune des deux faces 2, 2', aboutissant, pour une face, à une fracture et, pour l'autre face, à un bullage et/ou une exfoliation.

Lors de la fracture, le reste 6' (figure 3C) de la plaque 6 doublement implantée est séparé de la couche 5. Cette portion restante est donc libérée, mais en même temps que la contrainte au voisinage de chacune des deux faces 2, 2'. Ce reste 6' de plaque implantée n'est donc pas soumis brusquement à une courbure excessive. On évite ainsi une rupture indésirable de cette partie libérée 6' de la plaque implantée.

La face 2' ne nécessite aucune préparation de surface, puisque cette partie du substrat 6' n'est pas destinée à être assemblée avec un autre substrat hôte. Lors de la séparation au niveau du plan ou de la zone 4, il se produit donc, comme l'indique la figure 3C, au niveau du plan ou de la zone 4' implantée, la formation de bulles ou de cloques 15 ou une exfoliation (un éclatement de certaines des bulles ou des cloques 15), mais non une fracture totale au niveau de ce plan ou de cette zone 4'. Cet effet résulte en une réduction totale, ou presque, de la contrainte résultant de l'implantation 4'.

Si la plaque doublement implantée 6 et la seconde plaque 7 du collage ont des coefficients de dilatation thermique différents, par exemple tels que leur rapport soit supérieur ou égal à 2, on met alors en oeuvre avantageusement l'invention pour induire une modification de courbure: on induit volontairement une contrainte différente au voisinage de la face à coller 2 et au voisinage de la face 2' , opposée à la face 2, de la première plaque 6 implantée, par une différence de doses et/ou d'énergies d'implantation et/ou par une différence de type d'ions.

Il est également possible de réaliser, après assemblage des substrats 6 et 7, une deuxième étape d'implantation dans le substrat 6, afin de prévenir au moins partiellement une déformation ultérieure de la surface collée, qui serait notamment due à une différence entre les coefficients de dilatation thermique des substrats 6 et 7. Une deuxième étape d'implantation est illustrée sur la figure 3D, où un troisième faisceau 3" permet de réaliser, à travers la deuxième face 2', une troisième implantation 4", après assemblage du substrat 7 avec le substrat 6, qui a déjà subi deux implantation 3, 3' (figure 3A). Cette troisième implantation va induire une modification des contraintes, donc du moment de flexion de la première plaque. Cette troisième implantation permet de modérer une déformation induite ultérieurement au collage. Il s'agit par exemple d'une déformation induite par une augmentation de température.

L'effet de compensation disparaît, en même temps sur les deux faces de la première plaque 6, totalement ou partiellement, au moment de la fracture.

Le moment induit par la différence de contrainte permet d'adapter la courbure de la plaque 6 implantée pour permettre à la foins :
- d'induire un collage direct de bonne qualité, en modérant la courbure (ou la déformation) induite par implantation atomique ou ionique de la face 2 à coller,
- et de provoquer une séparation d'un film 5 par fracture en même temps qu'une disparition du moyen de modération de déformation: ce moyen résulte de la contrainte induite par implantation, contrainte qui disparait, ou presque, lors du traitement thermique de fracture, du fait de la formation de bulles et/ou de cloques et/ou de l'exfoliation comme expliqué ci-dessus. La destruction du reste 6' de la plaque implantée est évitée, destruction qui serait due, par exemple, au changement brusque de courbure.

Un exemple de réalisation va maintenant être donné.

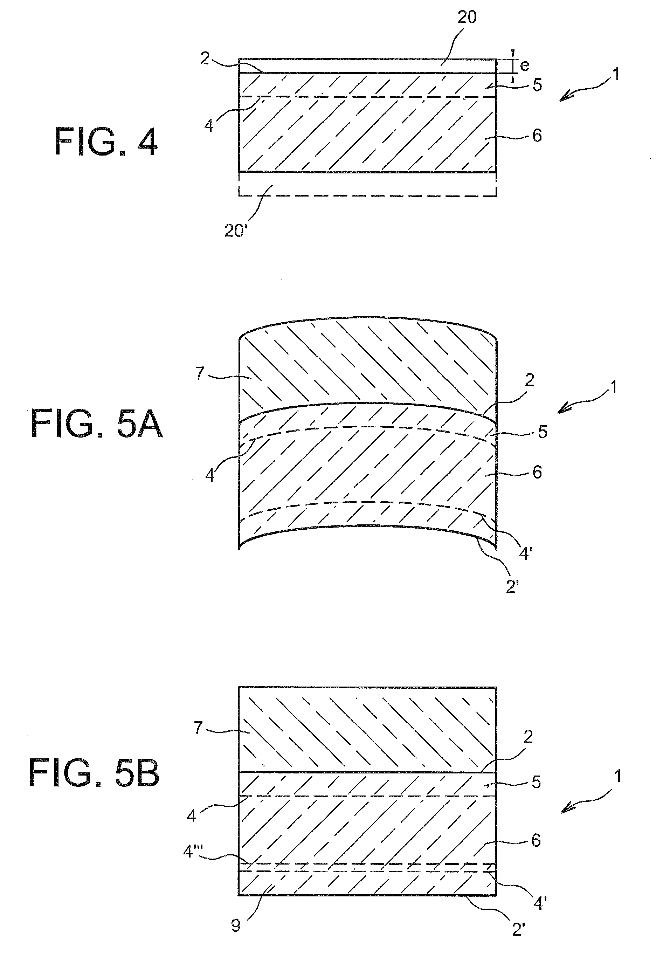

Le substrat initial 6 est un grenat de type SGGG (grenat de gallate de Gadolinium substitué, par exemple de composition Gd₃₋ₓ Caₓ Ga_{5-y-z} Mg_{y} Zr_{z} O₁₂) de diamètre 50 mm, sur lequel on a réalisé (figure 4), par épitaxie en phase liquide, un film 20 de grenat magnétique fortement concentré en bismuth, par exemple de composition Bi_{0,8} Tm_{0,25}Gd_{1,45}Pry_{0,35}) (Ga_{0,7} Fe_{4,3})O₁₂ et d'épaisseur e de l'ordre de 0.3 µm. La flèche de ce substrat initial 6 est inférieure à 5 µm après épitaxie.

Si la technique utilisée pour réaliser l'épitaxie est une technique d'épitaxie en phase liquide, alors on obtient un film épitaxié 20, 20' sur chacune des deux faces du substrat.

On réalise, à travers le film 20 de la face avant 2, une implantation ionique d'ions hydrogène 4, avec une énergie d'implantation de l'ordre de 110 KeV et une dose de l'ordre de 10¹⁷ ions H+ par centimètre carré.

On observe alors une déformation (une mise en convexité) de la plaque implantée 6, qui correspond à une mise en compression de la zone où a eu lieu l'implantation. Cette déformation peut être caractérisée par la mesure de la flèche induite lors de l'implantation (comme expliqué ci-dessus en liaison avec la figure 2A), cette flèche h est ici de l'ordre de 20 µm pour une mesure effectuée sur le diamètre de la plaque. Elle est trop importante pour permettre un collage ultérieur de bonne qualité, compte tenu de la raideur du substrat SGGG.

Conformément à l'enseignement de l'invention, on implante le substrat 6 du côté de la seconde face (à travers la couche 20' déposée sur la face arrière 2'), à la même dose et à la même énergie. La plaque ainsi doublement implantée présente une flèche inférieure à 5 µm, donc inférieure à la flèche initiale avant la seconde implantation. On a obtenu ainsi une modération de la courbure après la deuxième implantation.

On peut alors obtenir un collage de bonne qualité sur un support d'accueil 7 (figure 3B), par exemple un substrat de verre de 50 mm de diamètre.

Pour obtenir le détachement d'un film 5 de la plaque implantée 6 et son transfert sur le support d'accueil 7, on utilise un traitement thermique. Dans le cas du grenat et de l'implantation dans les conditions précitées, ce traitement thermique est par exemple de 480° pendant quatre heures.

Selon une variante de cet exemple on réalise une première implantation du substrat 6 avec des ions hélium, à une dose de 8.10¹⁶ par centimètre carré et à une énergie de 200 KeV.

Sans utiliser la technique de modération de déformation selon l'invention, on constate une flèche de l'ordre de 25 µm après cette première implantation 3. En utilisant la technique selon l'invention (implantation 3' à travers la seconde face 2'), on modère la déformation et la flèche est réduite, elle est inférieure à environ 5 µm.

Dans cet exemple et dans sa variante, on peut faire varier les épaisseurs de film épitaxié de grenat magnétique 20, 20', la nature des ions implantés 4, 4', la/les dose(s) et/ou l'énergie/les énergies d'implantation. Ceci sera par exemple le cas si le matériau n'est pas identique sur les deux faces 2, 2'.

Selon un autre exemple, un substrat 6 de SiC de diamètre 2.5 cm et d'épaisseur 230 µm subit une déformation de ~40 µm (mesurée sur son diamètre) lors d'une implantation unique (cas de la figure 1A) de l'ordre de 8 10¹⁶ H⁺ cm⁻², à une énergie de 120 KeV.

Pour une plaque de SiC de 350 µm d'épaisseur, la déformation, dans les mêmes conditions d'implantation, est de l'ordre de 18 µm.

Là encore, en appliquant le procédé selon l'invention, par une implantation identique en face arrière 2', la déformation est modérée (ou compensée). Elle peut n'être que de quelques µm, par exemple inférieure à 10 µm. Ce moyen de modération est supprimé en même temps que s'effectue la séparation du film 5, lors de l'étape de transfert sur un support 7, par exemple en SiC polycristallin ou en Silicium.

D'une façon générale, la technique de modération de déformation selon l'invention pourra être utilisée pour compenser tout ou partie d'une déformation initiale de la plaque à implanter. Cet avantage pourra être utilisé pour obtenir des collages de bonne qualité, après implantation.

Cette technique de modération de déformation peut également être utilisée pour compenser tout ou partie d'une déformation prévisible de la structure après empilement ou après traitement thermique. Dans ce cas, on peut par exemple adapter la dose implantée pour adapter la contrainte induite.

Cela signifie que la courbure finale d'une structure empilée dépend des contraintes présentes dans chacune des plaques de l'empilement, par le moment résultant. Si il est prévu que la structure empilée sera fortement courbée pendant le traitement thermique de fracture, on pourra modérer cet effet par une implantation ionique différente entre les deux plans d'implantation 4, 4'.

Ainsi la figure 5A représente un empilement de deux substrats 6, 7, dont l'un a subi deux implantations 4, 4'. L'empilement comporte encore une courbure, qui peut provenir par exemple d'une courbure du substrat 7, celui-ci imposant une courbure au substrat 6 doublement implanté lors de l'assemblage (et, de ce fait, plan ou de courbure fortement compensée). La double implantation du substrat 6 a donc un effet de modération de la courbure, mais n'est pas suffisante. On procède donc, après assemblage, à une implantation renforcée 4"', au voisinage de la surface 2', qui permet de réduire encore la courbure, comme le montre la figure 5B. Autrement dit, on réalise une modération de courbure qui permet un assemblage ou un collage, puis on rattrape une éventuelle flexion de la structure juste après assemblage ou collage. Une telle flexion peut être présente dès la température ambiante, c'est le cas notamment si la plaque 7 présente elle-même une déformation initiale.

## Revendications

1. Procédé de transfert d'une couche (5) en un premier matériau sur un deuxième substrat (7) en un deuxième matériau, comportant :
a) une étape de formation d'un premier plan de fragilisation (4) dans un premier substrat (6) en premier matériau, par une première implantation ionique et/ou atomique (3) à travers une première face (2) dudit substrat,
b) une étape de formation d'un deuxième plan de fragilisation (4') dans ledit premier substrat (6), par une deuxième implantation ionique et/ou atomique (3') à travers une deuxième face (2') dudit substrat, afin de réduire une courbure de ce premier substrat,
c) une étape d'assemblage des premier et deuxième substrats (6, 7), ou de dépôt du deuxième substrat sur le premier substrat,
d) une étape de séparation d'une couche du premier substrat au niveau du premier plan de fragilisation (4), sans séparation au niveau du deuxième plan de fragilisation.

2. Procédé selon la revendication 1, les implantations réalisées à travers, respectivement, la première et la deuxième faces (2, 2') étant réalisées sensiblement aux mêmes doses et aux mêmes énergies.

3. Procédé selon la revendication 1, les implantations réalisées à travers, respectivement, la première et la deuxième faces (2, 2') étant réalisées sensiblement à des doses et/ou des énergies différentes.

4. Procédé selon la revendication 3, le premier matériau et le deuxième matériau ayant des coefficients de dilatation thermique différents.

5. Procédé selon l'une des revendications 1 à 4, le premier substrat étant une plaque homogène.

6. Procédé selon l'une des revendications 1 à 4, le premier substrat comportant un ou plusieurs dépôts (20, 20'), sur l'une et/ou l'autre des première et deuxième faces.

7. Procédé selon l'une des revendications 1 à 5, le premier matériau étant de type grenat, ou en SiC ou en saphir.

8. Procédé selon la revendication 7, le premier substrat comportant un ou plusieurs dépôts (20, 20'), sur l'une et/ou l'autre des première et deuxième faces.

9. Procédé selon la revendication 8, le premier substrat comportant un ou plusieurs dépôts (20, 20'), sur l'une et/ou l'autre des première et deuxième faces, en grenat magnétique dopé au bismuth.

10. Procédé selon l'une des revendications 1 à 9, comportant, après l'étape c) et avant l'étape d), une étape supplémentaire d'implantation (3') à travers la deuxième face (2').

11. Procédé selon l'une des revendications 1 à 10, l'étape c) étant réalisée par collage direct ou adhésion moléculaire.

12. Procédé selon l'une des revendications 1 à 11, l'étape d) étant réalisée par traitement thermique.

13. Procédé selon l'une des revendications 1 à 12, le premier substrat (6) présentant une courbure avant l'étape a) et/ou la courbure étant créée ou accentuée par la première implantation ionique et/ou atomique (3) à travers la première face (2) dudit substrat.

## Patentansprüche

1. Verfahren zum Transferieren einer Schicht (5) aus einem ersten Material auf ein zweites Substrat (7) aus einem zweiten Material, umfassend:
a) einen Schritt des Bildens einer ersten Fragilisierungsebene (4) in einem ersten Substrat (6) aus erstem Material mittels einer ersten Ionen- und/oder Atomimplantation (3) durch eine erste Fläche (2) des Substrats hindurch,
b) einen Schritt des Bildens einer zweiten Fragilisierungsebene (4') in dem ersten Substrat (6) mittels einer zweiten Ionen- und/oder Atomimplantation (3') durch eine zweite Fläche (2') des Substrats hindurch, um eine Krümmung dieses ersten Substrats zu verringern,
c) einen Schritt des Zusammenfügens des ersten und des zweiten Substrats (6, 7) oder des Aufbringens des zweiten Substrats auf dem ersten Substrat,
d) einen Schritt des Separierens einer Schicht des ersten Substrats im Bereich der ersten Fragilisierungsebene (4) ohne Separierung im Bereich der zweiten Fragilisierungsebene.

2. Verfahren nach Anspruch 1, wobei die Implantationen, die durch die erste bzw. die zweite Fläche (2, 2') hindurch realisiert werden, im Wesentlichen mit gleichen Dosen und mit gleichen Energien realisiert werden.

3. Verfahren nach Anspruch 1, wobei die Implantationen, die durch die erste bzw. die zweite Fläche (2, 2') hindurch realisiert werden, im Wesentlichen mit unterschiedlichen Dosen und/oder Energien realisiert werden.

4. Verfahren nach Anspruch 3, wobei das erste Material und das zweite Material unterschiedliche thermische Ausdehnungskoeffizienten aufweisen.

5. Verfahren nach einem der Ansprüche 1 bis 4, wobei das erste Substrat eine homogene Platte ist.

6. Verfahren nach einem der Ansprüche 1 bis 4, wobei das erste Substrat ein oder mehrere Abscheidungen (20, 20') auf der einen und/oder der anderen von der ersten und der zweiten Fläche umfasst.

7. Verfahren nach einem der Ansprüche 1 bis 5, wobei das erste Material vom Typ Granat oder aus SiC oder aus Saphir ist.

8. Verfahren nach Anspruch 7, wobei das erste Substrat ein oder mehrere Abscheidungen (20, 20') auf der einen und/oder der anderen von der ersten und der zweiten Fläche umfasst.

9. Verfahren nach Anspruch 8, wobei das erste Substrat eine oder mehrere Abscheidungen (20, 20') auf der einen und/oder der anderen von der ersten und der zweiten Fläche aus magnetischem Granat umfasst, das mit Wismut dotiert ist.

10. Verfahren nach einem der Ansprüche 1 bis 9, umfassend nach dem Schritt c) und vor dem Schritt d) einen zusätzlichen Schritt der Implantierung (3') durch die zweite Fläche (2') hindurch.

11. Verfahren nach einem der Ansprüche 1 bis 10, wobei der Schritt c) durch direktes Kleben oder molekulare Adhäsion realisiert wird.

12. Verfahren nach einem der Ansprüche 1 bis 11, wobei der Schritt d) durch thermische Behandlung realisiert wird.

13. Verfahren nach einem der Ansprüche 1 bis 12, wobei das erste Substrat (6) vor dem Schritt a) eine Krümmung aufweist, und/oder wobei die Krümmung durch die erste Ionen- und/oder Atomimplantation (3) durch die erste Fläche (2) des Substrats hindurch erzeugt oder verstärkt wird.

## Claims

1. Method of transferring a layer (5) in a first material onto a second substrate (7) in a second material, comprising:
a) a step of forming a first embrittlement plane (4) in a first substrate (6) in first material, by a first ion and/or atom implantation (3) through a first face (2) of said substrate,
b) a step of forming a second embrittlement plane (4') in said first substrate (6), by a second ion and/or atom implantation (3') through a second face (2') of said substrate, in order to reduce a curvature of this first substrate,
c) a step of assembling the first and second substrates (6, 7), or depositing the second substrate on the first substrate,
d) a step of separating a layer from the first substrate at the level of the first embrittlement plane (4), without separation at the level of the second embrittlement plane.

2. Method according to claim 1, the implantations carried out through, respectively, the first and the second faces (2, 2') being carried out substantially at the same doses and at the same energies.

3. Method according to claim 1, the implantations carried out through, respectively, the first and the second faces (2, 2') being carried out substantially at different doses and/or energies.

4. Method according to claim 3, wherein the first material and the second material have different coefficients of thermal expansion.

5. Method according to any of claims 1 to 4, wherein the first substrate is a homogeneous wafer.

6. Method according to any of claims 1 to 4, wherein the first substrate comprises one or several deposits (20, 20'), on one and/or the other of the first and second faces.

7. Method according to any of claims 1 to 5, wherein the first material is of garnet type, or in SiC or in sapphire.

8. Method according to claim 7, the first substrate comprising one or several deposits (20, 20'), on one and/or the other of the first and second faces.

9. Method according to claim 8, wherein the first substrate comprises one or several deposits (20, 20'), on one and/or the other of the first and second faces, in bismuth doped magnetic garnet.

10. Method according to any of claims 1 to 9, comprising, after step c) and before step d), an additional implantation (3') step through the second face (2').

11. Method according to any of claims 1 to 10, wherein step c) is carried out by direct bonding or molecular adhesion.

12. Method according to any of claims 1 to 11, wherein step d) is carried out by heat treatment.

13. Method according to any of claims 1 to 12, wherein the first substrate (6) has a curvature before step a) and/or the curvature is created or accentuated by the first ion and/or atom implantation (3) through the first face (2) of said substrate.
